# EUROPEAN PATENT APPLICATION

(11) **EP 1 406 298 A1**
(43) Date of publication of application: **07.04.2004**
(21) Application number: 03022307.7
(22) Date of filing: 02.10.2003
(51) Int. Cl.: H01L 23/495, H01L 23/373

(54) **Semiconductor module and plate-shaped lead**

(30) Priority: 03.10.2002 JP 2002291214; 03.10.2002 JP 2002291217
(71) Applicant: Kabushiki Kaisha Toyota Jidoshokki, Kariya-shi, Aichi-ken 448-8671 (JP)
(72) Inventor: Sugiyama, Tomohei, Kariya-shi Aichi-ken, 448-8671 (JP); Kinoshita, Kyoichi, Kariya-shi Aichi-ken, 448-8671 (JP); Yoshida, Takashi, Kariya-shi Aichi-ken, 448-8671 (JP); Kudo, Hidehiro, Kariya-shi Aichi-ken, 448-8671 (JP); Tanaka, Katsufumi, Kariya-shi Aichi-ken, 448-8671 (JP); Kono, Eiji, Kariya-shi Aichi-ken, 448-8671 (JP)
(74) Representative: Leson, Thomas Johannes Alois, Dipl.-Ing.

(57) **Abstract**

A semiconductor module includes a substrate having opposite surfaces, a semiconductor device, and a plate-shaped lead. The semiconductor device is mounted on the substrate, and has opposite surfaces ahd electrodes. One of the opposite surfaces is disposed on the substrate. The electrodes are disposed on the other one of the opposite surfaces. The plate-shaped lead has an electrode joint joined to the electrodes, a wiring joint joined to a wiring unit disposed outside the semiconductor device, and a connector connecting the electrode joint and the wiring joint. At least the electrode joint includes a high thermal conductor, and a low expander disposed in the high thermal conductor. The semiconductor module is good in terms of the reliability and assembly easiness when wiring the electrodes of the semiconductor device.

## Description

### BACKGROUND OF THE INVENTION

### Field of the Invention

The present invention relates to a semiconductor module whose reliability is improved at the joint to electrodes of semiconductors, and to a plate-shaped lead used for the same.

### Description of the Related Art

Electrodes of semiconductor devices have been often connected to external terminals by wire bonding conventionally. The wire bonding is carried out by applying ultrasonic waves to aluminum wires while pressing the aluminum wires onto electrodes, joining counterparts. In this instance, oxide films are removed from the aluminum wires and electrodes to expose the fresh surfaces. Then, the aluminum wires and electrodes are welded over the fresh surfaces.

However, the wire bonding is carried out by applying loads and ultrasonic waves to the joining surfaces. Accordingly, the wire bonding is likely to cause the destruction and pressure-resistance degradation of semiconductor devices. Moreover, the joining area between wires and electrodes is small. Consequently, as temperature or heat cycles are repeated, cracks or come-offs might occur at the joint. In addition, a large number of wires are required to join semiconductor devices for large electric power applications, because the current-carrying capacity is less for each of wires. As a result, it takes longer to carry out the wire bonding so that it is difficult to improve the productivity.

Hence, many proposals have been made in which plate-shaped leads are used instead of linear wiring members (or leads) such as wires. It is possible to name the following patent publications which are relevant to the proposals: Japanese Unexamined Patent Publication (KOKAI) No. 6-268,027, Japanese Unexamined Patent Publication (KOKAI) No. 2000-277,558, Japanese Unexamined Patent Publication (KOKAI) No. 2002-43,508, and Japanese Unexamined Patent Publication (KOKAI) No. 11-163,045.

However, plate-shaped leads might suffer from drawbacks as hereinafter described. Firstly, a large thermal expansion might occur at joints, because the size of joints is larger than joints made of Wires. Moreover, plate-shaped leads comprise materials, such as Cu, whose thermal expansion coefficient is large. On the other hand, semiconductor devices, i . e . , mating members to be joined, comprise materials, such as Si, whose thermal expansion coefficient is small. Accordingly, a considerably larger thermal expansion difference might occur at joints between plate-shaped leads and electrodes of semiconductor devices compared with the case where wires and electrodes of semiconductor devices are joined by the wire bonding. In particular, the thermal expansion difference might enlarge around the joints of plate-shaped leads. As a result, temperature or heat cycles might cause large tensile stresses and compression stresses might act onto the periphery. Consequently, cracks might generate therefrom, and the resulting cracks might develop so that the joints are likely to come off. Thus, plate-shaped leads might cause the reliability of semiconductor devices to degrade.

Secondly, plate-shaped leads are wider than linear leads such as wires. Accordingly, due to the width, plate-shaped leads exhibit an enlarged rigidity configurationally even when plate-shaped leads and linear leads are made from the same materials. Consequently, it is difficult to join between electrodes with plate-shaped leads while elongating plate-shaped leads like wires. Thus, it is necessary to form plate-shaped wires as shapes conforming to joining members in advance. In addition, in this instance, it is required as well to form plate-shaped leads with high accuracy in order that electrodes are not subjected to excessive stresses. As a result, when plate-shaped leads are used, the productivity might be lowered, or the cost involved might go up.

Thirdly, semiconductor devices exhibit high temperatures in service. Accordingly, substrates and leads disposed in the vicinity also exhibit elevated temperatures. In particular, when semiconductor devices are powder devices, the semiconductor devices generate such a great quantity of heat that peripheral devices exhibit remarkably high temperatures as well. In this instance, when thermal expansion differences occur between the thermal expansions at opposite ends joined to plate-shaped leads, for example, thermal expansion differences occur between thermal expansions at electrodes of semiconductor devices and external terminals, and the thermal expansion of the plate-shaped leads themselves, stresses in proportion to the thermal expansion differences might act onto the plate-shaped leads and the joints. Therefore, even when plate-shaped leads are used, cracks or come-offs might also occur at joints.

### SUMMARY OF THE INVENTION

The present invention has been developed in view of such circumstances. It is therefore an object of the present invention to provide a semiconductor module which can further enhance the reliability or assembly easiness when semiconductor devices are wired by using plate-shaped leads. Moreover, it is another object of the present invention to provide a plate-shaped lead which can be used appropriately for the same.

Note that Japanese Unexamined Utility Model Publication (KOKAI) No. 63-20,448 discloses a heat spreader which is used to intervene between electrodes of semiconductor devices and wiring layers of substrates when semiconductor devices are mounted onto substrates, and which absorbs the thermal expansion coefficient difference between the semiconductors and the substrates. However, as the name implies, the heat spreader diffuses the heat of semiconductor devices being a heat generator to substrates, and is not used as wiring for electrodes intrinsically. Namely, the heat spreader functions differently than plate-shaped leads. Hence, it is pointed out herein that the utility model publication has nothing to do with the present invention directly or indirectly at all.

The inventors of the present invention have studied wholeheartedly in order to solve one of the problems at least. As a result of trial and error over and over again, they thought of a plate-shaped lead which could control the thermal expansion at the joint to electrodes and secure a radiating property at the joint. Thus, they believed that such a plate-shaped lead could improve the reliability of semiconductor modules. As a result, they arrived at completing the following first aspect of the present invention.

### (First Aspect of Present Invention)

### (1) Semiconductor Module

A semiconductor module according to the present invention comprises:
a substrate;
a semiconductor device mounted on the substrate, and having opposite surfaces and electrodes, one of the opposite surfaces disposed on the substrate, the electrodes disposed on the other one of the opposite surfaces; and
a plate-shaped lead having an electrode joint joined to the electrodes, a wiring joint joined to a wiring unit disposed outside the semiconductor device, and a connector connecting the electrode joint and the wiring joint;
at least the electrode joint comprising a high thermal conductor, and a low expander disposed in the high thermal conductor.

In the present semiconductor module, the electrode joint of the plate-shaped lead wired to the semiconductor module comprises a composite material which is of low expansion and high thermal conductivity.

Firstly, the composite material is composed of the high thermal conductor at the outer periphery which contacts with the electrodes of the semiconductor device. Accordingly, the heat generated by the semiconductor device can be transferred or conducted to the plate-shaped lead efficiently through the high thermal conductor. Specifically, the high thermal conductor functions as a great thermal pass. The heat absorbed by the plate-shaped lead is radiated through the connector or wiring joint of the plate-shaped lead, and is further radiated to the other substrates or heatsinks.

Thus, even when plate-shaped leads are used, it is possible to inhibit the electrode joint from exhibiting sharply elevated temperatures. As a result, it is possible to reduce the thermal expansion difference between the electrodes of the semiconductor device and the electrode joint of the plate-shaped lead. Moreover, it is possible to diminish the thermal stress arising between the electrodes and the electrode joint, thermal stress which results from the thermal expansion difference.

Secondly, the composite material involves the low expander disposed in the high thermal conductor. Accordingly, when the composite material is observed as a whole, the thermal expansion coefficient of the composite material is lowered compared with that of the simple high thermal conductor. As a result, when the plate-shaped lead comprises the composite material, it is possible as well to reduce the thermal expansion difference between the electrodes of the semiconductor device and the electrode joint of the plate-shaped lead compared with the case where plate-shaped leads comprise the high thermal conductor alone. Moreover, it is possible to diminish the thermal stress at the joint, thermal stress which results from the thermal expansion difference.

Thus, in accordance with the present invention, it is possible to control or inhibit cracks and peeling or exfoliation (hereinafter collectively referred to as "come-offs") , which occur between the electrodes of the semiconductor device and the electrode joint, by the synergetic effect of the high thermal conductor and low thermal expander. As a result, it is possible to improve the reliability of semiconductor modules as a whole.

### (2) Plate-shaped Lead

Not limited to the above-described present semiconductor module, it is possible to grasp the present invention as a plate-shaped lead itself. For instance, the present invention can be regarded as a plate-shaped lead comprising:
an electrode joint joined to electrodes of a semiconductor device mounted on a substrate, the electrodes disposed on one of opposite surfaces of the semiconductor device;
a wiring joint joined to a wiring unit disposed outside the semiconductor device;
a connector connecting the electrode joint and the wiring joint;
at least the electrode joint comprising a high thermal conductor, and a low expander disposed in the high thermal conductor.

### (Second Aspect of Present Invention)

Moreover, in order to solve one of the problems at least, the present inventors thought of a plate-shaped lead which could control or solve the factors of the degrading assembly easiness and lowering reliability which were caused by the thermal expansion difference. Thus, they believed that such a plate-shaped lead could improve the assembly easiness and reliability of semiconductor modules. As a result, they arrived at completing the following second aspect of the present invention.

### (2) Semiconductor Module

A semiconductor module according to the present invention comprises: a substrate;
a semiconductor device mounted on the substrate, and having opposite surfaces and electrodes, one of the opposite surfaces disposed on the substrate, the electrodes disposed on the other one of the opposite surfaces; and
a plate-shaped lead connecting the electrodes to a wiring unit disposed outside the semiconductor device;
the plate-shaped lead comprising:
   an electrode joint joined to the electrodes;
   a wiring joint joined to the wiring unit; and
   a low-rigidity portion disposed at least at a part between the electrode joint and the wiring joint, and exhibiting a low rigidity lower than an ambient rigidity.

Firstly, the present semiconductor module is free from the inconveniences associated with the wire bonding, because the electrodes of the semiconductor device are wired by using the plate-shaped lead.

Secondly, the present semiconductor module is improved more in terms of the assembly easiness (wiring easiness) and reliability than wire-bonded semiconductor modules, because the plate-shaped lead is provided with the low-rigidity portion.

The assembly easiness of the present semiconductor module is improved, because the plate-shaped lead is likely to deform at the low-rigidity portion. Specifically, even when the plate-shaped lead is not necessarily formed with high precision, or even when the joining positions deviate slightly, the low-rigidity portion of the plate-shaped lead can absorb the deviation and the like of the joining positions with ease. Note that the low-rigidity portion is likely to deform. Accordingly, the low-rigidity portion requires less load to deform. Consequently, the deformation of the low-rigidity portion applies less stress to the plate-shaped lead.

The reliability of the present semiconductor module is upgraded as well by disposing the low-rigidity portion, because the plate-shaped lead is likely to deform at the low-rigidity portion. A thermal expansion difference usually arises between plate-shaped leads and mating members, such as electrodes of semiconductor devices and wiring units of substrates, to which plate-shaped leads are joined. In this instance, the thermal expansion difference can be absorbed or relieved greatly by the deformation of the low-rigidity portion in the plate-shaped lead. Thus, the stress acting onto the entire plate-shaped lead can be mitigated. As a result, the thermal stresses acting onto the joints of the plate-shaped lead can be reduced naturally. Hence, it is possible to satisfactorily suppress cracks and come-offs at the joints of the plate-shaped lead.

### (2) Plate-shaped Lead

Not limited to the above-described present semiconductor module, it is possible to grasp the present invention as a plate-shaped lead itself. For instance, the present invention can be regarded as a plate-shaped lead connecting electrodes of a semiconductor device mounted on a substrate, the electrodes disposed on one of opposite surfaces of the semiconductor device which faces oppositely with respect to the substrate, with a wiring unit disposed outside the semiconductor device, the plate-shaped lead comprising:
an electrode joint joined to the electrodes;
a wiring joint joined to the wiring unit; and
a low-rigidity portion disposed at least at a part between the electrode joint and the wiring joint, and exhibiting a low rigidity lower than an ambient rigidity.

### (Others)

The first aspect and second aspect of the present invention can be coupled to make the present semiconductor modules and plate-shaped leads. For instance, a plate-shaped lead can comprise: an electrode joint comprising a high thermal conductor and a low expander disposed in the high thermal conductor; a wiring joint; and a low-rigidity portion disposed at least at a part between the electrode joint and the wiring joint, and exhibiting a low rigidity lower than an ambient rigidity. Of course, the present invention can be grasped as a semiconductor module provided with such a plate-shaped lead.

### BRIEF DESCRIPTION OF THE DRAWINGS

A more complete appreciation of the present invention and many of its advantages will be readily obtained as the same becomes better understood by reference tothefollowing detailed description when considered in connection with the accompanying drawings and detailed specification, all of which forms a part of the disclosure:
Fig. 1 is a major cross-sectional view for illustrating a semiconductor module according to Example No. 1 of the present invention;
Fig. 2A is a schematic diagram for illustrating a production process of a plate-shaped lead used in the semiconductor module according to Example No. 1;
Fig. 2B is another schematic diagram for illustrating the production process of the plate-shaped lead used in the semiconductor module according to Example No. 1;
Fig. 3 is a major cross-sectional view for illustrating a semiconductor module according to Example No. 2 of the present invention;
Fig. 4 is a major cross-sectional view for illustrating a semiconductor module according to Example No. 3 of the present invention;
Fig. 5A is a plan view for illustrating a plate-shaped lead according to Example No. 4 of the present invention;
Fig. 5B is a plan view for illustrating another plate-shaped lead according to Example No. 4 of the present invention;
Fig. 6 is a perspective view for illustrating a plate-shaped lead according to Example No. 5 of the present invention; and
Fig. 7 is perspective view for illustrating a plate-shaped lead according to Example No. 6 of the present invention.

### DETAILED DESCRIPTION OF THE PREFERRED EMBODIMENTS

Having generally described the present invention, a further understanding can be obtained by reference to the specific preferred embodiments which are provided herein for the purpose of illustration only and not intended to limit the scope of the appended claims.

Hereinafter, the present invention will be described more specifically while naming specific examples. Note that the following descriptions are appropriately applicable not only to the present semiconductor module but also to the present plate-shaped lead.

### (1) Plate-shaped Lead

"Plate-shaped" leads are leads whose width "w" is greater than the thickness "t." Note that the specific dimensions of the present plate-shaped lead do not matter at all. However, the width "w" can be substantially equal to that of electrodes of Semiconductor devices to which the present plate-shaped lead is joined. It is naturally possible to diminish the width "w" so that a plurality of the present plate-shaped leads can be disposed with respect to an electrode.

Firstly, the composite material making the present plate-shaped lead comprises a high thermal conductor and a low expander. Here, the high thermal conductor can be materials whose thermal conductivity is greater than that of the low expander. The low expander can be materials whose linear expansion coefficient is smaller than that of the high thermal conductor. The low expander can further preferably exhibit a linear expansion coefficient smaller than that of the electrodes of semiconductor devices. This is because the high thermal conductor exhibits a linear expansion coefficient far greater than that of the electrodes of semiconductor devices. In other words, the linear expansion coefficient of the low expander is diminished in order that the linear expansion coefficient of the composite material as a whole can be closer to that of the electrodes effectively.

The high thermal conductor can be pure metals or alloys whose major component is Cu or Al, for example. The metallic materials are preferable options, because the high thermal conductor is naturally responsible for the conductivity of the present plate-shaped lead as well. If the high thermal conductor working as a sheath exhibits poor wettability to solders when it is joined to the electrodes of semiconductor devices by solders, it is possible to appropriately carry out Ni, Au or Ag plating onto the surface of the high thermal conductor.

The low expander can be an invar alloy, for example, because invar alloys are less expensive and are good in terms of the formability. Note that, as an invar alloy, there are many invar alloys such as ferromagnetic invar alloys, Fe-based amorphous invar alloys and Fe-Ni-based antiferromagnetic invar alloys in which Cr substitutes for a part of Ni . Taking the service temperature range, processability, cost, being magnetic or nonmagnetic into consideration, it is possible to select invar alloys which are appropriate for the usage of plate-shaped leads. Accordingly, in the present invention, the type and composition of invar alloys are not limited in particular. When naming some of the examples, it is possible to use the well-known ferromagnetic invar alloys such as Fe-36%Ni (the unit being % by mass, being the same hereinafter) and Fe-31%-5%Co, a super invar alloy.

The composite material comprises the high thermal conductor, and the low expander disposed in the high thermal conductor, or involves the low expander within the high thermal conductor. However, it does not matter at all how the low expander is involved within the high thermal conductor or how the low expander is positioned in the high thermal conductor. The outer periphery of the low expander cannot necessarily be surrounded by the high thermal conductor completely. Even if such is the case, it is satisfactory because the heat transfer from semiconductor devices to the present plate-shaped lead and the heat conduction within the present plate-shaped lead can be carried out in desired ranges. For example, one and only low expander can be positioned in the high thermal conductor, or divided low expanders can be positioned therein.

However, it is suitable to position the low expander in the high thermal conductor in the middle at least in the thickness-wise direction. With such an arrangement, it is possible to inhibit the present plate-shaped lead from warping at the electrode joint. Accordingly, it is possible to suppress cracks and come-offs at the electrode joint. Moreover, it is preferable to position the low expander at the center, which is symmetrical in the width-wise direction, in the composite material or the present plate-shaped lead. With such an arrangement, it is possible for the present plate-shaped lead to uniformly expand thermally at the electrode joint. Consequently, it is possible to avoid applying unnecessary stresses to the electrode joint.

Moreover, when the volumetric ratio between the high thermal conductor and the low expander is adjusted appropriately, it is possible to control the thermal conductivity and low expandability of the composite material or the present plate-shaped lead. For example, when the volumetric occupation ratio of the low expander is enlarged, it is possible to diminish the thermal expansion of the entire composite material which makes the electrode joint of the present plate-shaped lead.

Note that it does not matter how the present plate-shaped lead is produced. However, it is possible to produce the present plate-shaped lead by the following production process, for example. A thin plate-shaped invar-alloy material is enveloped with a thin plate-shaped Cu material. Then, the resulting semi-finished workpiece is formed as desired shapes by pressing. In short, it is possible to use clad materials as the composite material.

It is satisfactory that the present plate-shaped lead can be provided with an electrode joint comprising the composite material. Moreover, the components other than the electrode joint, the wiring joint and the connector can further comprise the composite material. of course, only the electrode joint can comprise the composite material, and the wiring joint and connector can comprise simple materials such a Cu material.

Secondly, the "deformation" in the low-rigidity portion of the plate-shaped lead includes all deformations such as elongation, contraction, twist, and further composite deformations of these. Depending on the versatile deformations, the "rigidity" means tensile rigidity, compression rigidity, bending rigidity, and twisting rigidity. The low-rigidity portion can be formed by shaping the plate-shaped lead variously, or can be formed by varying the material composition at the low-rigidity portion. Moreover, the shaping and the material-composition varying can be combined to form the low-rigidity portion.

For example, when the low-rigidity portion is formed by shaping the plate-shaped lead, a part of the plate-shaped lead can be provided with a thin-thickness portion whose thickness is thinner than that of the joints, a narrow-width portion whose width is narrower than that of the joints, bellows, and a net-shaped expanded portion. When the low-rigidity portion is formed by varying the material composition at an intermediate of the plate-shaped lead, materials which exhibit a Young' s modulus smaller than that of the joints can be used to make a low-Young's modulus portion at an intermediate of the plate-shaped lead, or materials which exhibit a high Young' s modulus can be used otherwise for the joints to eventually make a low-Young's modulus portion at an intermediate of the plate-shaped lead. It is possible to produce such plate-shaped leads with ease by pressing Cu plates, for example.

In this instance, note that the plate-shaped lead can be laminated materials or composite materials involving an invar alloy therein. For example, when the electrode joint of the plate-shaped lead involves an invar alloy therein, it is possible to reduce the thermal expansion difference between the electrode joint and the electrodes of semiconductor devices. Accordingly, it is possible to further improve the reliability at the electrode joint.

### (2) Semiconductor Device

The types, shapes, standards and sizes of the semiconductor device do not matter at all. However, it is needless to say that the semiconductor device is provided with electrodes to which the present plate-shaped lead is joined. For example, when the semiconductor device is a power MOSFET (i.e., metal-oxide semiconductor field-effect transistor), or a power IGBT (i.e., insulated gate bipolar transistor), the electrodes are a source electrode, an emitter electrode, a drain electrode, a collector electrode, and a control (or gate) electrode. Depending on which one of the electrodes is joined to the wiring layer disposed on substrates, different electrodes are joined to the present plate-shaped electrode. For instance, when the drain electrode is soldered onto the wiring layer of a substrate, the source electrode and/or the gate electrode are connected to the wiring layer disposed on the substrate or to external terminals by the present plate-shaped lead. In this instance, only the source electrode in which a large electric current flows can be joined to the counter end by the present plate-shaped lead, and the gate electrode can be joined to the counter end by wire bonding.

### (3) Substrate

The substrate can be ceramic substrates, or metallic substrates. The substrate is properly provided with a wiring layer on one of the opposite surfaces or on both of the opposite surfaces. The wiring layer can be either Cu wiring layers or Al wiring layers, for example. Anyway, the types and shapes of the substrate and the forms of the wiring layer do not matter at all.

In the present invention, the semiconductor is "mounted" on the substrate. The phrase, "being mounted," implies that not only the semiconductor device can be packaged directly in the wiring layer of the substrate, but also the other component parts, such as heat spreaders, can intervene between the semiconductor device and the wiring layer of the substrate. The substrate is often joined to heatsinks or radiator plates for radiating heat. The radiator plates can be shared by the housing of semiconductor modules.

### (4) Wiring Unit

The wiring unit is disposed outside the semiconductor device, and is joined to the electrodes of the semiconductor device by the present plate-shaped lead. The wiring unit can comprise external terminals, or can be disposed on the wiring layer of the substrate. The substrate on which the wiring unit is disposed can be a distinct substrate. specifically, the distinct substrate can be prepared independently of the substrate on which the semiconductor device to be joined to the wiring unit by the present plate-shaped lead is mounted.

### (5) Supporter

The supporter supports the semiconductor device and the wiring unit. When the wiring unit is on the substrate on which the semiconductor device is mounted, the substrate makes the supporter. Moreover, heatsinks, radiator plates or housings, on which the substrate is mounted, can make the supporter. Thus, the supporter is a base for supporting the semiconductor device and the wiring unit.

Note that the support as well as the present plate-shaped lead receive heat from the semiconductor device. Accordingly, the support and the present plate-shaped lead exhibit high temperatures, and expand thermally. In this instance, due to the thermal expansion coefficient difference between the materials used in them and the temperature distribution difference between them, their thermal expansions differ usually.

If the thermal expansion on the present plate-shaped lead is smaller than the thermal expansion on the supporter, tensile forces act onto the present plate-shaped lead as the semiconductor device generates heat. In order to reduce the tensile force acting onto the entire present plate-shaped lead by absorbing the tensile force, it is preferable to dispose a low-rigidity portion at the connector, for example. The low-rigidity portion of the present plate-shaped lead warps more by the tensile force than its peripheral portions, and the thermal expansion difference is absorbed mainly at the low-rigidity portion. Accordingly, the tensile force acting onto the entire present plate-shaped lead can be relieved as a whole. As a result, it is possible as well to mitigate the stress acting eventually onto the electrode junction and wiring joint of the present plate-shaped lead. Consequently, it is possible to inhibit cracks and come-offs, which are accompanied by temperature or heat cycles, from occurring at the electrode joint and wiring joint.

The low-rigidity portion can make the entire connector or a part thereof. The following are some of the examples of the low-rigidity portion: thin-thickness portions whose thickness is thinner than that of the joints, narrow-width portions whose width is narrower than that of the joints, bellows, and net-shaped expanded portions.

Note that such a thermal expansion difference between the present plate-shaped lead and the supporter might cause a problem when the present plate-shaped lead comprises Cu materials whose major component is Cu and the supporter comprises Al materials whose major component is Al, for example. Note that the expression, "materials whose major component is a certain element," means that the materials can be pure metals or their alloys. When the thermal expansion on the present plate-shaped lead is greater than the thermal expansion on the supporter, compression stresses act onto the present plate-shaped lead naturally. In this instance, the foregoing descriptions are applicable essentially as well.

### (6) Applications

The applications of the present semiconductor module are not limited in particular. However, the present semiconductor module is especially suitable for appliances which are required to be highly reliable. The present semiconductor module is particularly suitable for appliances on which power-electronic semiconductors are mounted and which are exposed to violently changing service environments, such as temperature variations (i.e., temperature or heat cycles), for example, in-vehicle appliances.

### EXAMPLES

The present invention will be hereinafter described more specifically with reference to specific examples according to the present semiconductor module and plate-shaped lead.

### (Example No. 1)

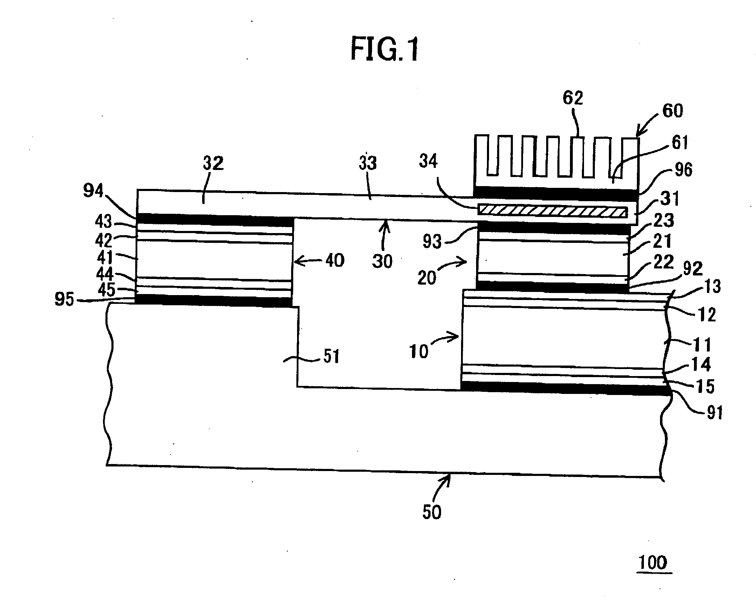

A semiconductor module 100, Example No. 1 according to the present invention, is used in an inverter for controlling the operation of three-phase induction motors (or hereinafter simply referred to as "three-phase motors") . Fig. 1 illustrates a major cross-section of the semiconductor module 100.

The semiconductor module 100 comprises a device-side metallic base-wiring substrate 10, a semiconductor device 20, a plate-shaped lead 30, a terminal-side metallic base wiring substrate 40, a supporter 50, and a radiator plate 60.

On a surface of the device-side metallic base-wiring substrate 10, the semiconductor device 20 is packaged. The device-side metallic base-wiring substrate 10 comprises a base substrate 11 made of Al, and wiring layers 13, 15 made of Cu. The wiring layers 13, 15 are bonded to the opposite surfaces of the base substrate 11 by way of insulation layers 12, 14, respectively. Note that it is possible to abbreviate the insulation layer 14 and the wiring layer 15 as far as the device-side metallic wiring substrate 10 is joined to the supporter 50 by solder.

The semiconductor device 20 is an IGBT device, and comprises a body 21, a drain electrode 22, a source electrode 23 and a gate electrode (not shown). The drain electrode 22 is disposed on the bottom surface of the body 21. The source electrode 23 and the gate electrode are disposed on the top surface of the body 21.

The plate-shaped lead 30 comprises an electrode joint 31 disposed at one of the opposite ends, a terminal joint (i.e., a wiring joint) 32 disposed at the other one of the opposite ends, and a connector 33 connecting the electrode joint 31 with the terminal joint 32. In Example No. 1, the terminal joint 31 is soldered to the source electrode 23 of the semiconductor device 20, and comprises a laminated material (i.e., a composite material) formed by pressurizing. The laminated material comprises a thin copper plate (i.e., a high thermal conductor), and a plate-shaped material (i.e., a low expander) disposed in the thin copper plate and made of an invar alloy (e.g., Fe-36%Ni). Note that the terminal joint 32 and the connector 33 are free from the invar alloy plate-shaped material disposed therein, and are made by simply laminating the copper plates. The production process of the plate-shaped lead 30 will be described later in detail.

Thus, the electrode joint 31 of the plate-shaped lead 30 is formed as a three-layer structure comprising a Cu layer, an invar alloy layer 34, and a Cu layer. The respective layers have a thickness of about 1/3 of the entire thickness of the plate-shaped lead 30, respectively. The invar alloy layer 34 is disposed at the middle of the thickness-wise direction, and is formed as symmetrical in the horizontal direction. Hence, the plate-shaped lead 30 is inhibited from warping at the electrode joint 31. For instance, the overall thickness of the plate-shaped lead 30 is from 0.05 to 1 mm approximately.

Note that the size of the invar alloy layer 34 is substantially identical with that of the source electrode 23. Thus, the linear expansion coefficient of the electrode joint 31 approaches the linear expansion coefficient of the source electrode 23. As a result, the thermal expansion difference is further diminished between the electrode joint 31 and the source electrode 23 so that it is possible to relieve the thermal stress acting onto the joint.

Moreover, the Cu layers surround the ends of the electrode joint 31 (e.g., the right end in Fig. 1 and the opposite ends in the direction perpendicular to the sheet of Fig. 1). Accordingly, the ends of the plate-shaped lead 30 protrude slightly beyond the source electrode 23. Thus, the heat generated by the semiconductor device 20 is not shut off by the invar alloy layer 34, but detours around the periphery of the invar alloy layer 34. Consequently, the heat generated by the semiconductor device 20 can move (or conduct thermally) from the semiconductor device 20 to the radiator plate 60 efficiently.

The terminal-side metallic base-wiring substrate 40 makes an external terminal. Similarly to the device-side metallic base-wiring substrate 10, the terminal-side metallic base-wiring substrate 40 comprises a base substrate 41 made of Al, and wiring layers 43, 45 made of Cu. The wiring layers 43, 45 are bonded to the opposite surfaces of the base substrate 41 by way of insulation layers 42, 44, respectively. In the terminal-side metallic base-wiring substrate 40 as well, it is possible to abbreviate the insulation layer 44 and the wiring layer 45 as far as the terminal-side metallic wiring substrate 40 is joined to the supporter 50 by solder.

The supporter 50 is a heatsink made of an Al alloy. However, the supporter 50 can be shared by the housing of the semiconductor 100.

The radiator plate 60 is also a heatsink made of an Al alloy. The radiator plate 60 comprises a base 61, and a plurality of fins 62 protruding from the base 61.

Hereinafter, how the constituent elements are joined will be described. First, the device-side metallic base-wiring substrate 10 is fixed to the inner bottom surface of the supporter 50 by way of a solder layer 91. The drain electrode 22 of the semiconductor device 20 is joined onto the wiring layer 13 of the device-side metallic base-wiring substrate 10 by way of a solder layer 92. Further, the terminal-side metallic base-wiring substrate 40 is fixed onto a protrusion 51 of the supporter 50 by way of a solder layer 95. Furthermore, the source electrode 23 of the semiconductor device 20 is joined to the electrode joint 31 of the plate-shaped lead 30 by way of a solder layer 93; and the wiring layer 43 of the terminal-side metallic base-wiring substrate 40 is joined to the terminal joint 32 of the plate-shaped lead 30 by way of a solder layer 94, respectively. Thus, the source electrode 23 and the wiring layer 43, a source pattern, are connected electrically by the plate-shaped lead 30. Moreover, the radiator plate 60 is joined onto the top (i.e., the opposite side with respect to the semiconductor device 20) of the electrode joint 31 of the plate-shaped lead 30 by way of a solder layer 96.

In Example No. 1, the heat generated by the semiconductor device 20 is transferred to the Cu layer of the electrode joint 31 through the source electrode 23 and the solder layer 93. The Cu layer of the electrode joint 31 transfers the heat from the semiconductor 20 to the radiator plate 60. Here, note that the heat hardly dwells at the joint between the source electrode 23 and the electrode joint 31 of the plate-shaped lead 31, because the Cu layer is a high thermal conductor. Accordingly, the heat is conducted from the surface of the electrode joint 31 to the radiator plate 60 through the solder layer 96, and is radiated efficiently at the radiator plate 60 having a large superficial area. Thus, it is possible to inhibit the electrode joint 31 from exhibiting abnormally high temperatures.

Moreover, in Example No. 1, the electrode joint 31 exhibits a reduced linear expansion coefficient partially because the invar alloy layer 34 exists. Therefore, the thermal expansion difference between the electrode joint 31 and the source electrode 23 is diminished as well.

Thus, it is possible to keep the temperature from increasing at the joint between the electrode joint 31 and the source electrode 23. At the same time, it is possible to further relieve the thermal stress acting onto the joint, because the thermal expansion difference between them is diminished. Accordingly, it is possible to effectively suppress or inhibit cracks and come-offs from occurring at the joint between them. Consequently, the semiconductor module 100 can be improved in terms of the reliability.

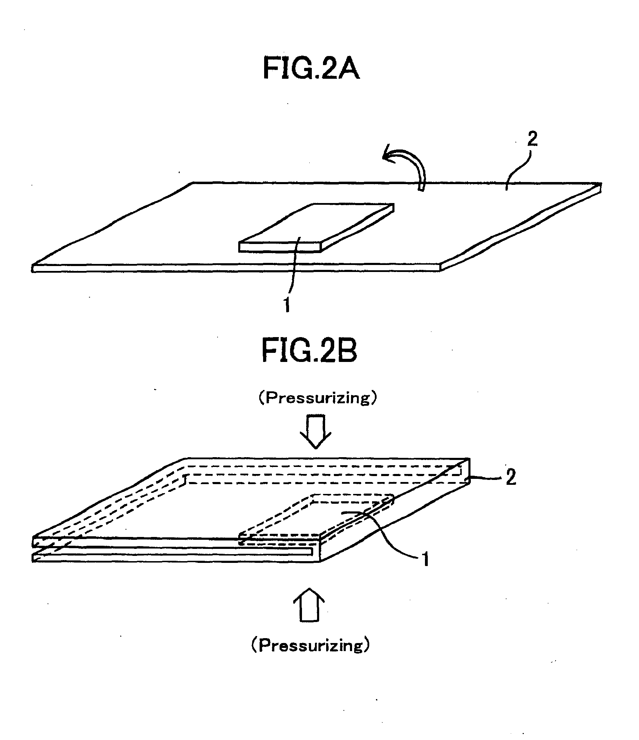

Hereinafter, how to produce the plate-shaped lead 30 will be described with reference to Figs. 2A and 2B. Firstly, an invar alloy thin plate 1 is placed at the substantial center on a Cu thin plate 2 as illustrated in Fig. 2A. The Cu plate 2 has a size slightly larger than that of the plate-shaped lead 30. Secondly, the Cu thin plate 2 is held at one of the opposite ends, and is bent over so as to envelope the invar alloy thin plate 1 in the direction designated by the arrow of Fig. 2A.

Thirdly, the invar alloy thin plate 1 and the Cu thin plate 2 which are turned into a three-layer construction partially are formed by pressurizing them from the top and bottom surfaces as illustrated in Fig. 2B in a high-temperature atmosphere. In short, the invar alloy thin plate i and the Cu thin plate 2 are hot formed by pressing. The pressurized invar alloy thin plate 1 and Cu thin plate 2 are left as they are for a certain period of time in order to join the respective layers by diffusion. Finally, the resulting raw workpiece is cut to a desired size. Thus, the plate-shaped lead 30 can be produced.

### (Example No. 2)

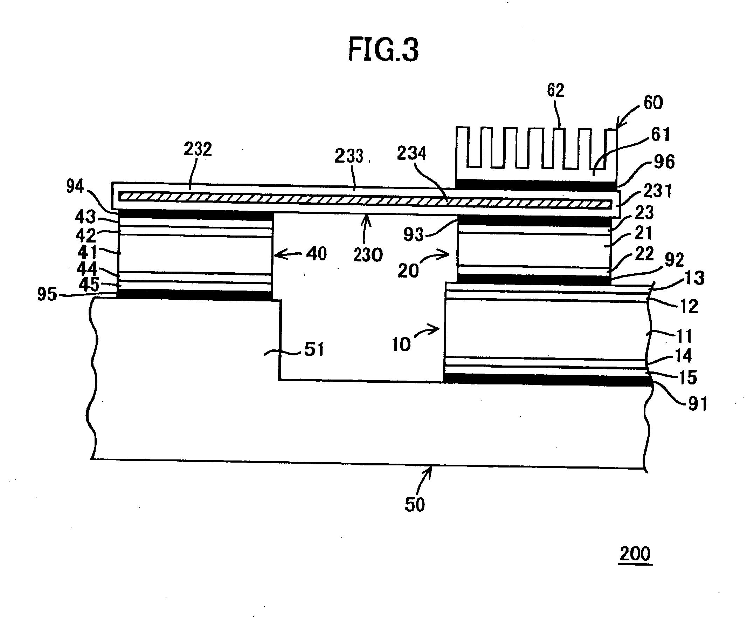

A semiconductor module 200 according to Example No. 2 will be hereinafter described with reference to Fig. 3. The semiconductor module 200 comprises a plate-shaped lead 230. The plate-shaped lead 230 includes a three-layer construction of an invar alloy and Cu layers not only at an electrode joint but also the entirety substantially. In the drawing, like reference numerals designate like constituent elements in Example No. 1.

In Example No. 2, the plate-shaped lead 230 can be produced with ease, because it comprises the 3-layer construction as a whole substantially. Accordingly, it is possible to reduce the cost of the semiconductor module 200. The plate-shaped lead 230 can be produced by the above-described production process. Alternatively, the plate-shaped lead 230 can be produced by copper plating the periphery of an invar alloy thin plate as well.

In addition, in Example Nos. 1 and 2, the size of the low expander within the electrode joint is virtually equal to the size of the electrode of the semiconductor. However, it is possible to control the area ratio of the low expander with respect to the electrode in a range of from -60% to +60%, for instance.

### (Example No. 3)

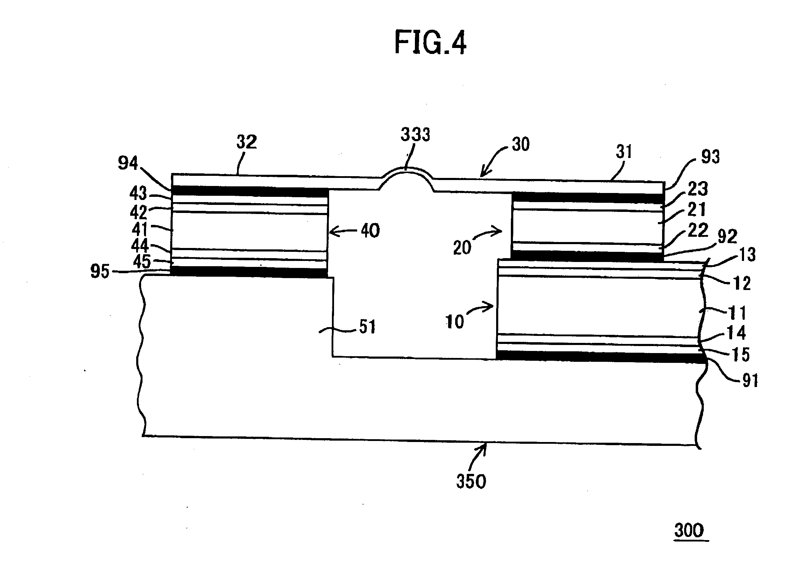

A semiconductor module 300, Example No. 3 according to the present invention, is also used in an inverter for controlling the operation of three-phase motors. Fig. 4 illustrates a major cross-section of the semiconductor module 300. In the drawing, like reference numerals designate like constituent elements in Example No. 1 wherever appropriate.

The semiconductor module 300 comprises a device-side metallic base-wiring substrate 10, a semiconductor device 20, a plate-shaped lead 30, a terminal-side metallic base wiring substrate 40, and a radiator 350.

On a surface of the device-side metallic base-wiring substrate 10, the semiconductor device 20 is packaged. The device-side metallic base-wiring substrate 10 comprises a base substrate 11 made of Al, and wiring layers 13, 15 made of Cu. The wiring layers 13, 15 are bonded to the opposite surfaces of the base substrate 11 by way of insulation layers 12, 14, respectively. As noted in the semiconductor module 100 according to Example No. 1, it is possible as well to abbreviate the insulation layer 14 and the wiring layer 15 as far as the device-side metallic wiring substrate 10 is joined to the radiator 350 by solder. The semiconductor device 20 is an IGBT device, and comprises a body 21, a drain electrode 22, a source electrode 23 and a gate electrode (not shown). The drain electrode 22 is disposed on the bottom surface of the body 21. The source electrode 23 and the gate electrode are disposed on the top surface of the body 21.

The plate-shaped lead 30 is formed as a strip-shaped wiring member by pressing a thin copper plate. The plate-shaped lead 30 comprises an electrode joint 31 at one of the opposite ends, a terminal joint (i.e., a wiring joint) 32 at the other one of the opposite ends, and a low-rigidity portion 333 disposed at the substantial center and bent as an arc shape. The low-rigidity portion 333 is composed of a thin-thickness portion formed thinner than the electrode joint 31 and terminal joint 32. Specifically, the plate-shaped lead 30 has a thickness of 0.15 mm at the low-rigidity portion 333, and has a thickness of 0.3 mm at the other portions. Note that, in Example No. 3, the plate-shaped lead 30 has a width of 7 mm so as to be equal to that of the source electrode 23. Although the plate-shaped lead 30 is made of Cu, it can be made of Al. Moreover, it is possible to use laminated materials, in which an invar alloy is enclosed, for the plate-shaped lead 30. The plate-shaped lead 30 can be subjected to Ni plating or Au plating in order to upgrade the wettability to solders.

Moreover, the plate-shaped lead 30 shown in Fig. 4 is protruded outward (or upward) at the low-rigidity portion 333. Meanwhile, when the plate-shaped lead 30 is protruded inward (or downward) at the low-rigidity portion 333, the overall height of the semiconductor module 300 is reduced so that the semiconductor module 300 can be downsized.

The terminal-side metallic base-wiring substrate 40 makes an external terminal. Similarly to the device-side metallic base-wiring substrate 10, the terminal-side metallic base-wiring substrate 40 comprises a base substrate 41 made of Al, and wiring layers 43, 45 made of Cu. The wiring layers 43, 45 are bonded to the opposite surfaces of the base substrate 41 by way of insulation layers 42, 44, respectively. In the terminal-side metallic base-wiring substrate 40 as well, it is possible to abbreviate the insulation layer 44 and the wiring layer 45 as far as the terminal-side metallic wiring substrate 40 is joined to the radiator 350 by solder.

The radiator 350 is a heatsink made of an Al alloy. However, the radiator 350 can be shared by the housing of the semiconductor 300.

Hereinafter, how the constituent elements are joined will be described. First, the device-side metallic base-wiring substrate 10 is fixed to the inner bottom surface of the radiator 350 by way of a solder layer 91. The drain electrode 22 of the semiconductor device 20 is joined onto the wiring layer 13 of the device-side metallic base-wiring substrate 10 by way of a solder layer 92. Moreover, the terminal-side metallic base-wiring substrate 40 is fixed onto a protrusion 51 of the radiator 350 by way of a solder layer 95. In addition, the source electrode 23 of the semiconductor device 20 is joined to the electrode joint 31 of the plate-shaped lead 30 by way of a solder layer 93; and the wiring layer 43 of the terminal-side metallic base-wiring substrate 40 is joined to the terminal joint 32 of the plate-shaped lead 30 by way of a solder layer 94, respectively. Thus, the source electrode 23 and the wiring layer 43, a source pattern, are connected electrically by the plate-shaped lead 30.

In Example No. 4, the low-rigidity portion 333 comprising a thin-thickness portion relives the thermal stress acting onto the plate-shaped lead 30. As a result, cracks and come-offs are inhibited from occurring at the electrode joint 31 and terminal joint 32 so that it is possible to improve the semiconductor module 30 in terms of the reliability as whole. Moreover, it is easy to join the plate-shaped lead 30 to the device-side metallic base-wiring substrate 10 and terminal-side metallic base-wiring substrate 40, because the plate-shaped lead 30 is likely to deform at the low-rigidity portion 333.

### (Example No. 4)

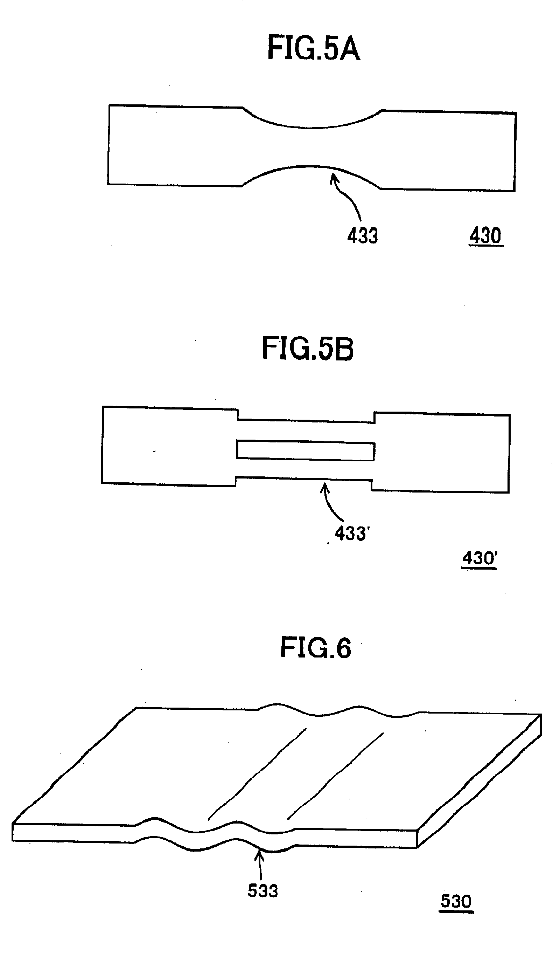

Fig. 5A illustrates a plate-shaped lead 430 according to Example No. 4. As shown in the drawing, the plate-shaped lead 430 has a low-rigidity portion 433 whose width is reduced instead of the thin-thickness low-rigidity portion 330 of the plate-shaped lead 30 according to Example No. 3. In Example No. 4, portions other than the plate-shaped lead 430 will not be described, because they are identical with those of Example No. 3. The manner of description follows hereinafter unless otherwise specified.

In addition to the low-rigidity portion 433 illustrated in Fig. 5A, note that the inside of the plate-shaped lead 430 can be punched out partially to make a low-rigidity portion 433' as illustrated in Fig. 5B. The number of the punched-out holes can be plural. The hole can be punched out as any shapes, such as rectangular shapes, circular shapes and elliptic shapes.

### (Example No. 5)

Fig. 6 illustrates a plate-shaped lead 530 according to Example No. 5. As shown in the drawing, the plate-shaped lead 530 has a low-rigidity portion 533 formed as a bellows instead of the thin-thickness low-rigidity portion 330 of the plate-shaped lead 30 according to Example No. 3.

### (Example No. 6)

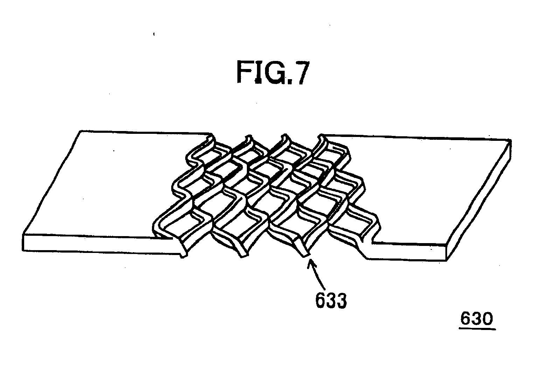

Fig. 7 illustrates a plate-shaped lead 630 according to Example No. 6. As shown in the drawing, the plate-shaped lead 630 has a low-rigidity portion 633 formed as a net-shaped expander instead of the thin-thickness low-rigidity portion 330 of the plate-shaped lead 30 according to Example No. 3.

All of the plate-shaped leads 433, 533 and 633 can be formed by pressing with ease. Note that, however, it is possible to produce plate-shaped leads by welding joints to the opposite ends of low-rigidity portions which are prepared in advance.

Having now fully described the present invention, it will be apparent to one of ordinary skill in the art that many changes and modifications can be made thereto without departing from the spirit or scope of the present invention as set forth herein including the appended claims.

A semiconductor module includes a substrate having opposite surfaces, a semiconductor device, and a plate-shaped lead. The semiconductor device is mounted on the substrate, and has opposite surfaces and electrodes. One of the opposite surfaces is disposed on the substrate. The electrodes are disposed on the other one of the opposite surfaces. The plate-shaped lead has an electrode joint joined to the electrodes, a wiring joint joined to a wiring unit disposed outside the semiconductor device, and a connector connecting the electrode joint and the wiring joint. At least the electrode joint includes a high thermal conductor, and a low expander disposed in the high thermal conductor. The semiconductor module is good in terms of the reliability and assembly easiness when wiring the electrodes of the semiconductor device.

## Claims

1. A semiconductor module, comprising:
a substrate;
a semiconductor device mounted on the substrate, and having opposite surfaces and electrodes, one of the opposite surfaces disposed on the substrate, the electrodes disposed on the other one of the opposite surfaces; and
a plate-shaped lead having an electrode joint joined to the electrodes, a wiring joint joined to a wiring unit disposed outside the semiconductor device, and a connector connecting the electrode joint and the wiring joint;
at least the electrode joint comprising a high thermal conductor, and a low expander disposed in the high thermal conductor.

2. The semiconductor module set forth in claim 1, wherein the low expander comprises a material whose linear expansion coefficient is smaller than that of the electrodes.

3. The semiconductor module set forth in claim 1, wherein the low expander comprises an invar alloy.

4. The semiconductor module set forth in claim 1, wherein the high thermal conductor comprises a pure metal or alloy whose major component is copper (Cu) or aluminum (Al).

5. A plate-shaped lead, comprising:
an electrode joint joined to electrodes of a semiconductor device mounted on a substrate, the electrodes disposed on one of opposite surfaces of the semiconductor device;
a wiring joint joined to a wiring unit disposed outside the semiconductor device;
a connector connecting the electrode joint and the wiring joint;
at least the electrode joint comprising a high thermal conductor, and a low expander disposed in the high thermal conductor.

6. A semiconductor module, comprising:
a substrate;
a semiconductor device mounted on the substrate, and having opposite surfaces and electrodes, one of the opposite surfaces disposed on the substrate, the electrodes disposed on the other one of the opposite surfaces; and
a plate-shaped lead connecting the electrodes to a wiring unit disposed outside the semiconductor device;
the plate-shaped lead comprising:
an electrode joint joined to the electrodes;
a wiring joint joined to the wiring unit; and
a low-rigidity portion disposed at least at a part between the electrode joint and the wiring joint, and exhibiting a low rigidity lower than an ambient rigidity.

7. The semiconductor module set forth in claim 6 further comprising a supporter supporting the semiconductor device and the wiring unit; and the plate-shaped lead exhibiting a thermal expansion which differs from that of the supporter.

8. The semiconductor module set forth in claim 7, wherein the plate-shaped lead comprises a Cu material whose major component is copper (Cu); and the supporter comprises an Al material whose major component is aluminum (Al).

9. The semiconductor module set forth in claim 8, wherein the substrate makes the support.

10. The semiconductor module set forth in claim 6, wherein the low-rigidity portion comprises at least one member selected from the group consisting of thin-thickness portions, narrow-width portions, bellows, expanded portions and low-Young's modulus portions.

11. A plate-shaped lead connecting electrodes of a semiconductor device mounted on a substrate, the electrodes disposed on one of opposite surfaces of the semiconductor device which faces oppositely with respect to the substrate, with a wiring unit disposed outside the semiconductor device, the plate-shaped lead comprising:
an electrode joint joined to the electrodes;
a wiring joint joined to the wiring unit; and
a low-rigidity portion disposed at least at a part between the electrode joint and the wiring joint, and exhibiting a low rigidity lower than an ambient rigidity.
